# FASCICULE DE BREVET EUROPEEN

(11) **EP 0 780 952 B1**
(45) Date de publication et mention de la délivrance du brevet: **27.02.2002**
(21) Numéro de dépôt: 96410125.7
(22) Date de dépôt: 17.12.1996
(51) Int. Cl.: H02H 9/02

(54) **Composant statique et monolithique limiteur de courant et disjoncteur**
Monolithischer und statischer Strombegrenzer und Schutzschalter
Monolithic and static current limiter and circuit breaker

(30) Priorité: 20.12.1995 FR 9515508
(43) Date de publication de la demande: 25.06.1997
(73) Titulaire: STMicroelectronics S.A., 92120 Montrouge (FR)
(72) Inventeur: Quoirin, Jean-Baptiste, 37000 Tours (FR); Sanchez, Jean-Louis, 31750 Escalquens (FR); Jallade, Jean, 31320 Castanet Tolosan (FR)
(74) Mandataire: de Beaumont, Michel

(56) Documents cités:
- EP-A- 0 557 850
- WO-A-95/07548
- DE-A- 2 460 422

## Description

La présente invention concerne le domaine des composants semiconducteurs et plus particulièrement des composants de moyenne ou forte puissance.

Dans ce domaine, on connaît des composants destinés à être disposés en série avec une charge et ayant pour fonction de limiter le courant dans cette charge à une valeur maximum prédéterminée. Pour cela, on utilise par exemple un transistor MOS à déplétion dont la grille est connectée à la source.

On connaît aussi des composants ayant une fonction de disjoncteur.

Le brevet US 5272399 décrit un circuit de limitation de courant associé à un commutateur de puissance.

Le brevet WO 95/07548 décrit un circuit discret comprenant en série un limiteur de courant et un disjoncteur à commande en courant.

Un objet de la présente invention est de prévoir un nouveau type de composant statique et monolithique ayant la double fonction de limiteur de courant et de disjoncteur. Un tel composant laisse passer un courant de valeur limitée tant que la tension à ses bornes n'excède pas un seuil de déclenchement déterminé puis interrompt la circulation de courant au-delà de ce seuil.

Un autre objet de la présente invention est de réaliser un tel composant qui soit autoréamorçable, c'est-à-dire qui refonctionne en limiteur de courant dès que la tension à ses bornes passe en dessous d'un seuil de réamorçage déterminé.

Pour atteindre ces objets, la présente invention prévoit un composant statique et monolithique limiteur de courant et disjoncteur comprenant, entre deux bornes, un limiteur de courant à conduction unidirectionnelle et un détecteur de la tension entre lesdites bornes, et comprenant en outre un moyen d'inhibition de la conduction du limiteur de courant quand la tension détectée dépasse un seuil déterminé.

Selon un mode de réalisation de la présente invention, le détecteur de tension est un diviseur de tension.

Selon un mode de réalisation de la présente invention, le diviseur de tension comprend deux transistors MOS à déplétion à canal N connectés en série entre lesdites bornes.

Selon un mode de réalisation de la présente invention, le moyen d'inhibition est un commutateur statique en série avec le limiteur de courant.

Selon un mode de réalisation de la présente invention, le limiteur de courant est un transistor MOS à canal N à déplétion de type vertical.

Selon un mode de réalisation de la présente invention, le limiteur de courant est un transistor vertical de type IGBT à déplétion.

Selon un mode de réalisation de la présente invention, le limiteur de courant est un transistor bipolaire NPN dont le collecteur est relié à la base par l'intermédiaire d'un transistor MOS à canal N à déplétion.

Selon un mode de réalisation de la présente invention, le limiteur de courant est un transistor MOS latéral à canal P à déplétion à substrat flottant dont le drain est connecté à la cathode d'un thyristor vertical, un transistor MOS à canal N à déplétion étant disposé entre cathode et gâchette d'anode du thyristor.

Selon un mode de réalisation de la présente invention, le diviseur comprend un premier transistor MOS à canal N à déplétion de type vertical et un deuxième transistor MOS à canal N à déplétion de type latéral.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente la caractéristique courant-tension d'un dispositif selon la présente invention ;
les figures 2A et 2B sont deux schémas sous forme de blocs illustrant les éléments principaux d'un dispositif selon la présente invention ;
les figures 3A et 3B sont respectivement une représentation symbolique et une vue en coupe schématique d'un premier mode de réalisation d'un limiteur de courant selon la présente invention ;
les figures 4A et 4B sont respectivement une représentation symbolique et une vue en coupe schématique d'un deuxième mode de réalisation d'un limiteur de courant selon la présente invention ;
les figures 5A et 5B sont respectivement une représentation symbolique et une vue en coupe schématique d'un troisième mode de réalisation d'un limiteur de courant selon la présente invention ;
les figures 6A et 6B sont respectivement une représentation symbolique et une vue en coupe schématique d'un quatrième mode de réalisation d'un limiteur de courant selon la présente invention ;
la figure 7A est une représentation symbolique d'un diviseur de tension selon un mode de réalisation de la présente invention, et les figures 7B et 7C sont des vues en coupe schématiques de modes de réalisation du diviseur de tension de la figure 7A ;
la figure 8A est une vue en coupe schématique d'un premier mode de réalisation d'un limiteur-disjoncteur selon la présente invention et les figures 8B et 8C sont des schémas équivalents du limiteur-disjoncteur de la figure 8A ; et
la figure 9A est une vue en coupe schématique d'un deuxième mode de réalisation d'un limiteur-disjoncteur selon la présente invention et la figure 9B est un schéma de circuit équivalent du composant de la figure 9A.

De façon générale, conformément à l'usage, les figures constituant des vues en coupe de composants semiconducteurs ne sont pas à l'échelle, ni à l'intérieur d'une figure donnée, ni d'une figure à l'autre. L'homme de l'art se référera à ses connaissances générales pour la détermination des épaisseurs et des niveaux de dopage des diverses couches. Les surfaces occupées par ces diverses couches ou le nombre de cellules constituant un composant élémentaire seront, de façon connue, choisis en fonction de la technologie utilisée et des impératifs de dissipation de puissance.

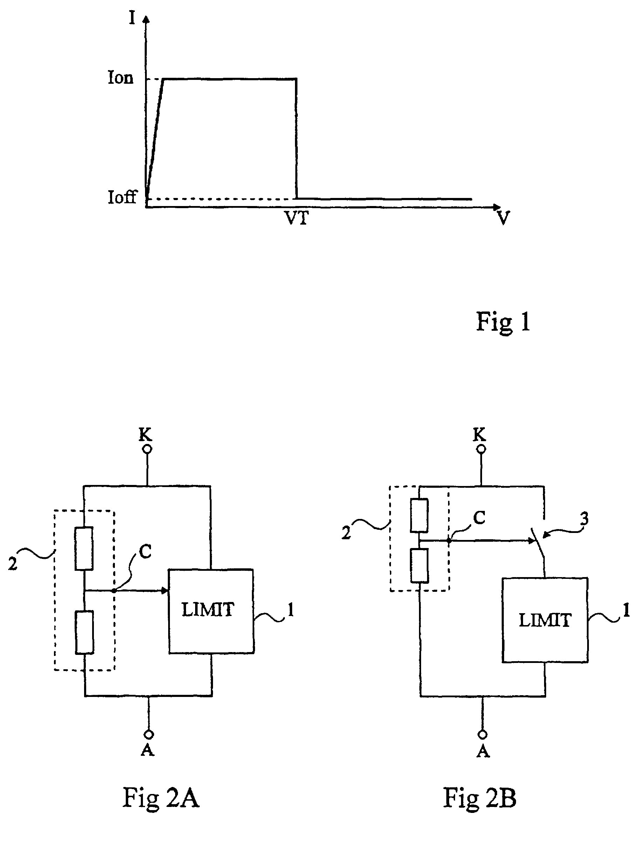

La présente invention vise à réaliser un composant statique et monolithique ayant la caractéristique illustrée en figure 1.

Tant que la tension est inférieure à une tension de seuil VT, le courant dans le composant est limité à une valeur Ion sensiblement constante. Dès que la tension aux bornes du composant dépasse la valeur VT, le courant chute à une valeur Ioff faible devant Ion, d'où il résulte que le courant dans le circuit incluant le composant est sensiblement interrompu.

La figure 2A représente sous forme de blocs la structure générale d'un composant selon la présente invention. Ce composant est destiné à être connecté entre des bornes A et K, la borne A ou borne d'anode étant positive par rapport à la borne K ou borne de cathode. Il comprend, entre ces bornes, un limiteur de courant 1 et un détecteur de tension 2. Le détecteur de tension est par exemple un diviseur de tension qui fournit sur une borne C une tension de commande VC quand la tension entre les bornes A et K atteint la valeur de seuil VT. La tension VC commande le limiteur de courant 1 pour inhiber son fonctionnement, c'est-à-dire le rendre bloquant.

Dans le mode de réalisation illustré en figure 2B, le détecteur de tension entraîne l'ouverture d'un commutateur 3, en série avec le limiteur 1, quand la tension entre les bornes A et K atteint la valeur VT.

### LIMITEUR DE COURANT

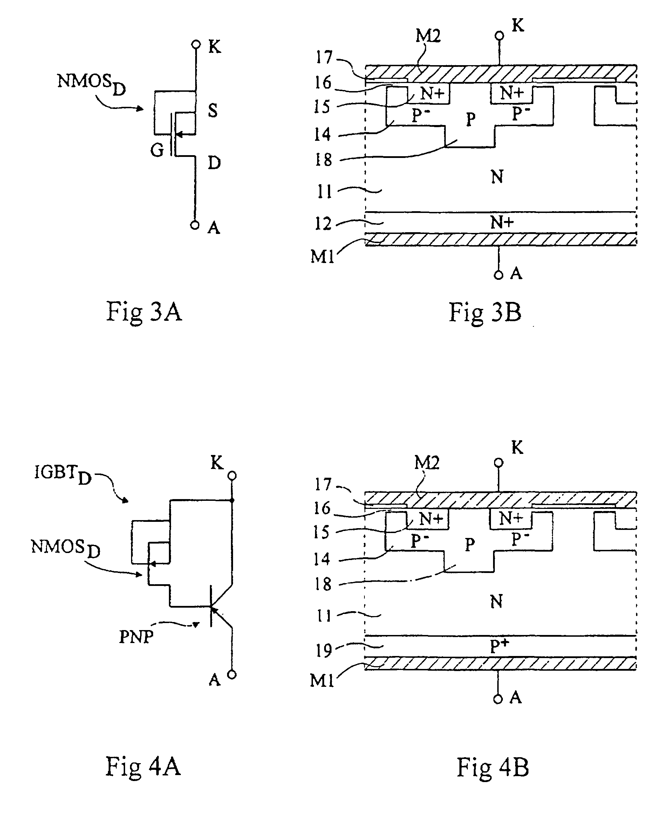

Les figures 3 à 6 représentent divers modes de réalisation possibles d'un limiteur de courant adapté à la présente invention, c'est-à-dire susceptible d'une intégration monolithique avec les autres éléments du composant selon l'invention. Notamment, ce limiteur est de type vertical et comprend une première électrode sur une première face principale du composant et une deuxième électrode sur la deuxième face principale du composant.

Le limiteur de courant de la figure 3A est un transistor MOS à canal N à déplétion (NMOS_{D}) dont la grille est connectée à la source.

La figure 3B représente une vue en coupe schématique simplifiée d'un exemple de réalisation d'un tel composant.

Ce composant est formé dans une tranche de silicium 11 de type N à faible niveau de dopage comprenant du côté de sa face arrière une couche 12 fortement dopée de type N permettant la réalisation d'un contact ohmique avec une métallisation d'anode M1 recouvrant la face arrière. Le transistor NMOS_{D} est réalisé sous forme verticale pour permettre la dissipation d'une puissance importante. Il comprend une ou plusieurs cellules dont chacune est formée dans un caisson de type P faiblement dopé 14 ayant par exemple en vue de dessus une forme hexagonale ou carrée. Du côté de la face supérieure du caisson 14 est formé une région 15 de type N⁺ ayant sensiblement une forme en anneau. La partie supérieure du caisson 14 entre la périphérie externe de l'anneau 15 et la périphérie externe du caisson 14 est occupée par une région de type N faiblement dopée 16 revêtue d'un isolant de grille 17. La partie centrale du caisson 14 correspond généralement à une région de type P plus fortement dopée 18. La face supérieure du composant est revêtue d'une métallisation de cathode M2.

Ainsi, de façon connue, la face arrière du composant correspond au drain du transistor MOS, la région 15 à sa source, la partie surdopée 18 au contact de substrat du transistor MOS et la région 16 à la région de canal. La métallisation M2 constitue, au-dessus de la région d'isolement de grille 17, le contact de grille ; au-dessus de la région 15, le contact de source ; et, au-dessus de la région 18, le contact de substrat. On obtient donc bien un composant ayant une fonction correspondant au schéma de la figure 3A.

Ce composant est connu en lui-même et est susceptible de diverses variantes de réalisation bien connues de l'homme de métier.

La figure 4B représente une variante du composant de la figure 3B dans laquelle la couche semiconductrice de face arrière 12 de type N fortement dopée est remplacée par une couche 19 de type P fortement dopée. On obtient alors, de façon connue, un composant dit transistor bipolaire à grille isolée (IGBT) à déplétion (IGBT_{D}) dont le schéma équivalent est illustré en figure 4A. Ce composant équivaut à un transistor PNP dont l'émetteur correspond à la couche 19, la base à la région faiblement dopée 11 et le collecteur aux régions P 14, 18. Un transistor MOS vertical à canal N à déplétion, identique à celui de la figure 3B, se trouve connecté par sa borne de source à la borne K et par sa borne de drain à la base du transistor PNP et assure donc, par le maintien d'un courant de collecteur-base constant, la circulation d'un courant constant entre collecteur et émetteur du transistor PNP.

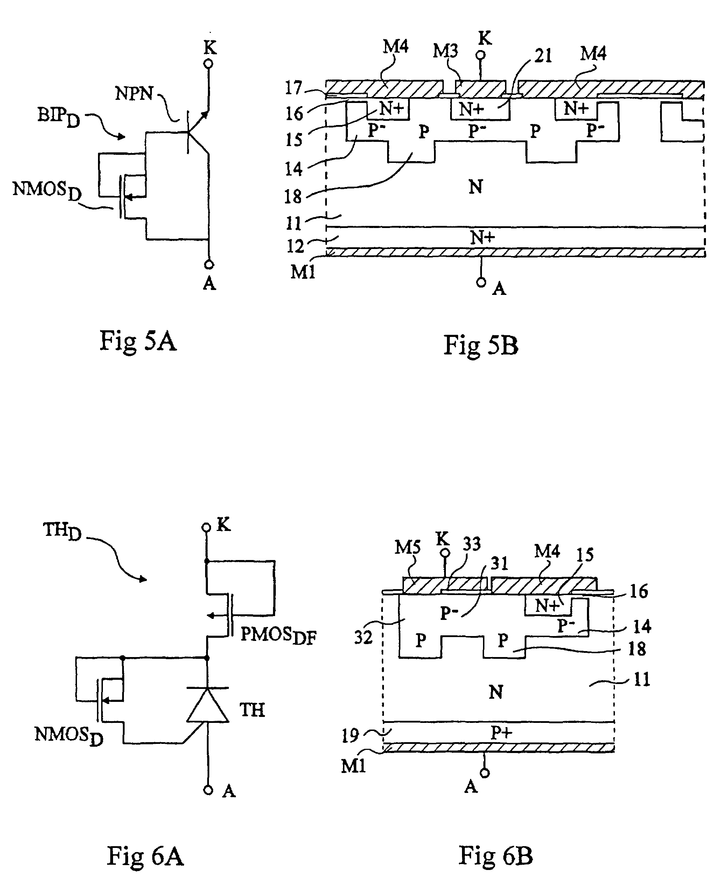

Dans le schéma de la figure 5A, il est prévu comme limiteur de courant un composant comprenant entre les bornes A et K un composant BIP_{D} comprenant, entre les bornes A et K, un transistor bipolaire de type NPN dont le collecteur est relié à la borne A et l'émetteur à la borne K. La base de ce transistor NPN est reliée à son collecteur par l'intermédiaire d'un transistor NMOS_{D} tel que décrit précédemment. Le maintien d'un courant collecteur-base constant dans ce transistor NPN sous l'effet du transistor NMOS_{D} assure le maintien d'un courant constant entre collecteur et émetteur. On notera que la prévision d'un tel composant constitue un aspect de la présente invention.

Un exemple de réalisation du composant de la figure 5A est illustré dans la vue en coupe schématique de la figure 5B. On retrouve dans ce composant les mêmes éléments que ceux de la figure 3B désignés par les mêmes références numériques pour constituer un transistor MOS vertical à canal N à déplétion comprenant notamment les régions et couches désignées par les références 11-12 et 14-18. A nouveau, la face arrière est revêtue d'une métallisation uniforme d'anode M1. Une particularité de la structure de la figure 5B réside dans le fait que la partie centrale, interne à la région 15 de type N⁺, est occupée par une région de type N fortement dopée 21. Cette région 21 est formée dans une portion à faible niveau de dopage du caisson 14 et est revêtue d'une métallisation M3 connectée à la cathode K. En outre, une métallisation M4 constitue la métallisation de grille, de source et de contact caisson du transistor NMOS_{D}. Cette métallisation M4, par son contact avec la région de caisson 18, constitue la connexion à la base du transistor NPN. Ce transistor NPN a pour émetteur la région 21, pour base la région 18 et pour collecteur les régions 11, 12.

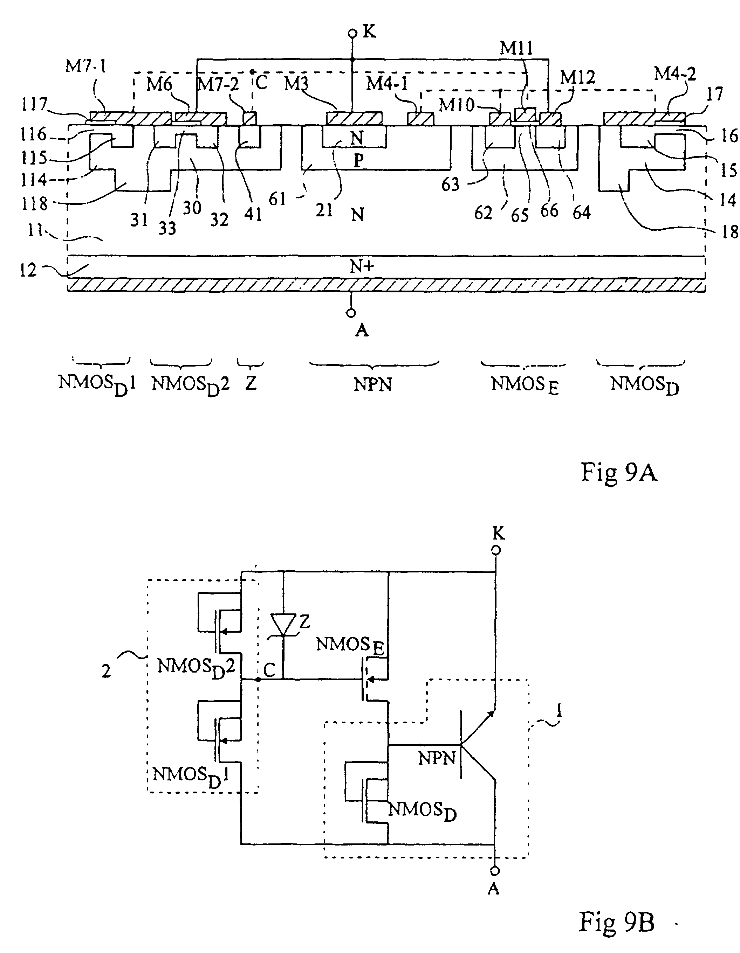

Cette réalisation est susceptible de nombreuses variantes qui apparaîtront à l'homme de l'art. Notamment, il conviendra d'optimiser le dopage de la région P 18 pour optimiser le gain du transistor NPN. Dans une variante de réalisation, on pourra séparer le caisson de base du transistor NPN du caisson du transistor NMOS_{D}. Alors, ces caissons seront connectés par une métallisation. Un tel mode de réalisation sera décrit ci-après en relation avec la figure 9A et présente l'avantage de permettre une optimisation des niveaux de dopage des caissons en fonction des caractéristiques recherchées du transistor NPN et du transistor NMOS_{D}.

La figure 6A représente le schéma d'une structure TH_{D} dans laquelle le composant limiteur de courant est un transistor MOS à canal P à déplétion à substrat flottant PMOS_{DF}. Ce transistor PMOS_{DF} est réalisé sous forme d'un transistor MOS latéral. Ainsi, pour assurer que les électrodes principales du limiteur du courant sont disposées sur les faces principales opposées du composant, ce transistor PMOS_{DF} est en série avec un thyristor TH. La mise en conduction du thyristor TH est assurée par la connexion en série de sa cathode et d'une région de gâchette d'anode par l'intermédiaire d'un transistor MOS à déplétion à canal N NMOS_{D}.

La figure 6B représente un exemple de mise en oeuvre du circuit de la figure 6A. On retrouve dans la partie droite de la figure 6B des régions semiconductrices similaires à celles décrites dans les figures précédentes. On notera que la couche semiconductrice de face arrière est une couche 19 de type P⁺ comme dans le cas de la figure 4B. Ainsi, l'ensemble des couches et régions 15, 14, 11 et 19 forme un thyristor TH. La région N+ 15 forme avec la région de canal 16 et la région faiblement dopée 11 un transistor NMOS à déplétion. La métallisation M4 correspond à une connexion grille-source du transistor NMOS_{D} et à la cathode du thyristor TH. En outre, la métallisation M4 s'étend au-dessus de la région de type P plus fortement dopée 18. Cette structure comprend, de façon adjacente à la région 18, une région P⁻ 21 et une région P 32. La région P⁻ 21 est surmontée d'une couche d'isolement de grille 33 et une métallisation M5 est en contact avec la région 32 et s'étend au-dessus de la région d'isolement de grille 33. Ainsi, les régions 18, 31 et 32 forment un transistor MOS à déplétion dont le substrat correspond à la région N 11. Ce substrat, non connecté à la source du transistor, est flottant. On a donc obtenu un transistor MOS à canal P à déplétion à substrat flottant PMOS_{DF}. La métallisation de source-grille M5 est reliée à la borne K. La métallisation de drain est constituée par la métallisation M4. La structure de la figure 6B correspond donc à la structure de la figure 6A, la borne K étant formée sur la face supérieure et la borne A sur la face inférieure. Ainsi, le rôle du thyristor TH est de reporter sur la face arrière la métallisation de drain du transistor PMOS_{DF} et le rôle du transistor NMOS_{D} et de rendre passant ce thyristor.

### DETECTEUR DE TENSION

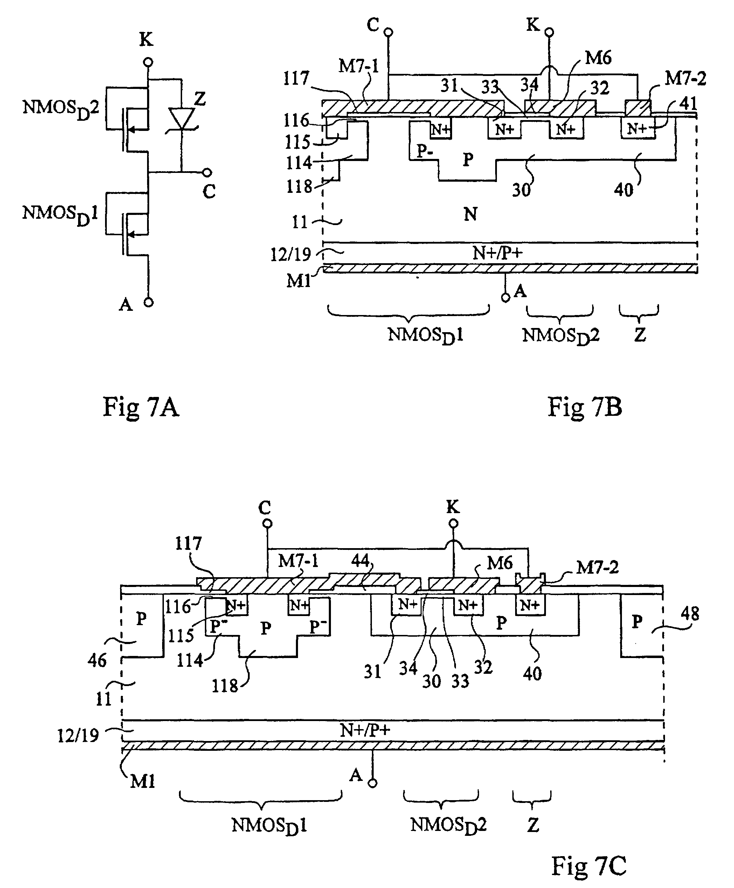

La figure 7A représente un exemple de détecteur de tension utilisable dans un composant selon la présente invention. Ce détecteur de tension est constitué d'un diviseur de tension comprenant deux transistors MOS à canal N à déplétion connectés en série et fonctionnant en tant que résistances, c'est-à-dire avant d'arriver dans leur région de fonctionnement en limitation de courant. Chacun de ces transistors MOS a sa grille connectée à sa source. La borne A est connectée au drain d'un premier transistor NMOS_{D}1 et la borne K à la source-grille du deuxième transistor NMOS_{D}2. En outre, on a représenté sur le schéma équivalent une diode zener Z dont l'anode est reliée à la borne K et la cathode au point de connexion C des deux transistors.

La figure 7B représente un premier exemple de réalisation du circuit de la figure 7A.

Le transistor NMOS_{D}1 représenté dans la partie gauche de la figure est un transistor MOS vertical à canal N à déplétion ayant sensiblement la même structure que celui représenté en figure 3B. On a utilisé des références 114-118 pour désigner des régions correspondant à celles désignées par les références 14-18 en figure 3B. On notera que, du côté de la face arrière du composant, on peut prévoir une couche N⁺ 12 ou une couche P⁺ 19 et que cela ne modifiera sensiblement pas le fonctionnement du transistor NMOS_{D}1 puisque, si cette couche de face arrière est une couche 19 de type P⁺, la jonction P⁺ N entre les couches 19 et 11 est polarisée en direct, cette face arrière étant destinée à être connectée à une borne d'anode A qui est la plus positive des tensions appliquées au composant.

Le transistor NMOS_{D}2 est formé dans une extension 30 du caisson de type P faiblement dopé 114 ou dans un caisson de type P distinct sous forme d'un transistor MOS latéral classique comprenant une région de drain 31 de type N⁺ et une région de source 32 de type N ⁺ séparées par une région de canal préformé 33 de type N faiblement dopée. La région de canal est surmontée d'une couche d'isolement de grille 34.

La diode zener Z est formée dans une extension 40 du caisson 114 ou dans un caisson distinct et comprend dans la face supérieure de ce caisson une région de type N⁺ 41.

Une métallisation M6 correspond à la source et à la grille du transistor NMOS_{D}2 et est reliée à la borne de cathode K. Une métallisation M7-1 correspond à la grille, à la source et au contact de caisson du transistor NMOS_{D}1 ainsi qu'au drain du transistor NMOS_{D}2 et est reliée à la borne C. Une métallisation M6-2 en contact avec la région de cathode 41 de la diode zener Z est également reliée à la borne C. On notera que l'anode de la diode zener Z, correspondant au caisson 40, est connectée à la borne K par l'intermédiaire d'une extension de la métallisation M6 sur le caisson 40.

La figure 7C représente une variante de la figure 7B dans laquelle les caissons 30, 40 ont été séparés du caisson 114, 118. En conséquence, la métallisation M7-1 rejoint la région de drain 31 du transistor NMOS_{D}2 en passant au-dessus d'une région d'isolement 44.

En figure 7C, on a représenté les régions d'isolement formées à la partie supérieure du composant, autres que les régions d'isolement de grille, comme plus épaisses que ces régions d'isolement de grille. Ceci correspondra à des réalisations pratiques et n'a pas été représenté précédemment par souci de simplicité. On notera aussi que, selon le processus de fabrication utilisé, on pourra trouver plus de deux épaisseurs distinctes de couches d'isolement à la surface supérieure du composant, certaines de ces couches d'isolement correspondant à ce que l'on désigne généralement sous l'appellation "oxyde épais" dans le cadre de la fabrication des transistors MOS.

Egalement, en figure 7C, on a représenté aux limites de la structure, des caissons de type P 46 et 48. Ces caissons pourront être des caissons spécifiquement prévus pour tenir la haute tension dans la structure ou pourront être des caissons comprenant d'autres éléments d'un composant plus complexe.

### LIMITEUR-DISJONCTEUR

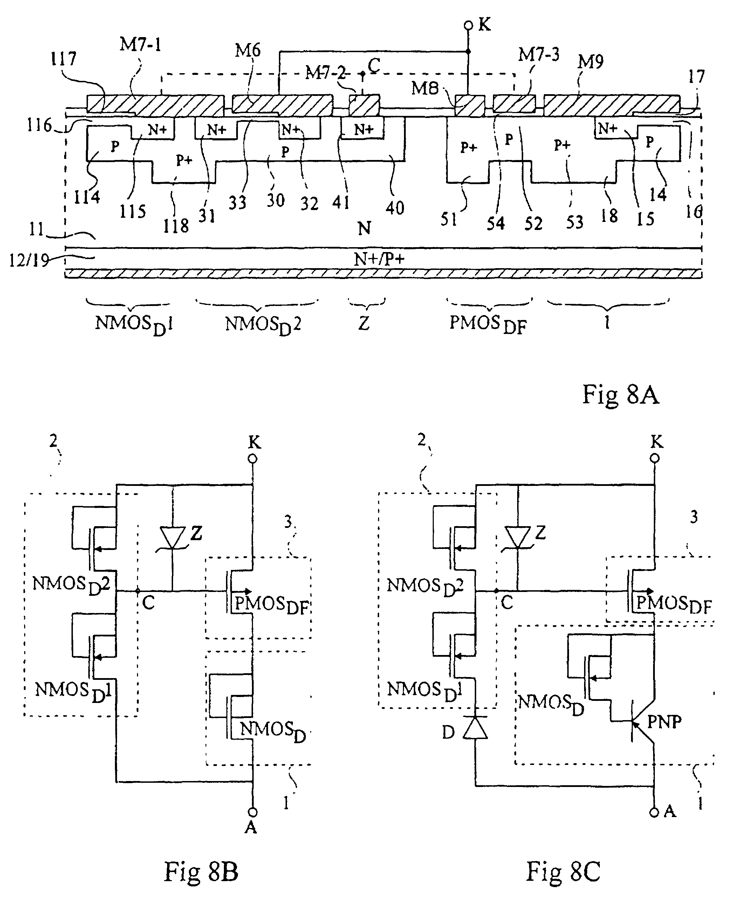

La figure 8A est une vue en coupe schématique d'un premier mode de réalisation d'un composant limiteur disjoncteur selon la présente invention. Selon que la couche de face arrière du composant est de type N⁺ ou P⁺, ce composant correspond au schéma équivalent de la figure 8B ou de la figure 8C.

Les schémas des figures 8B et 8C correspondent à des réalisations du schéma général de la présente invention précédemment décrit en relation avec la figure 2B. Le limiteur 1 est réalisé sous forme d'un transistor MOS à canal N à déplétion à grille et source interconnectées NMOS_{D} dans le cas de la figure 8B, et sous forme d'un transistor IGBT à déplétion dans le cas de la figure 8C. Le détecteur de tension 2 est réalisé sous forme d'un diviseur comprenant deux transistors MOS à canal N à déplétion NMOS_{D}1 et NMOS_{D}2. Le commutateur 3 est réalisé sous forme d'un transistor MOS à canal P à déplétion à substrat flottant PMOS_{DF}. En plus de ce qui apparaît dans le schéma de la figure 2B, on a représenté en figures 8B et 8C une diode zener Z de protection de grille du transistor PMOS_{DF}. En outre, en figure 8C, il apparaît une diode D. Il ne s'agit pas d'un élément nécessaire au fonctionnement du circuit mais d'un élément inhérent à sa réalisation qui correspond à la jonction entre une région de face arrière 19 de type P⁺ et le substrat 11 de type N. Il est clair que cette diode D ne perturbe pas le fonctionnement car elle est polarisée en direct. Cette diode est d'autant moins gênante qu'il circule normalement un courant très faible dans la branche comprenant le diviseur 2. Sa chute de tension en direct devra seulement être prise en compte pour la détermination du seuil de déclenchement de l'interrupteur 3.

Ainsi, la figure 8A reprend dans sa partie gauche les éléments représentés en figure 7B. On retrouve notamment les transistors NMOS_{D}1 et NMOS_{D}2 et la diode Z. Dans la partie droite de la figure on retrouve, selon que la couche inférieure est de type N⁺ ou P⁺, la structure de la figure 3B ou celle de la figure 4B. Ces éléments, décrits précédemment, ne seront pas décrits à nouveau. Ils sont désignés par de mêmes références en figure 8A que dans les figures précédentes.

L'interrupteur 3 est réalisé sous forme d'un transistor MOS latéral à canal P à déplétion à substrat flottant PMOS_{DF} comprenant une région de drain 51 de type P fortement dopée, une région de canal préformé 52 de type P faiblement dopée et une région de source 53 de type P fortement dopée qui, dans ce mode de réalisation, est commune avec la région 18 du transistor NMOS_{D}.

Sur la partie correspondant au diviseur de tension, on retrouve les mêmes métallisations M7-1, M6 et M7-2 que celles décrites en relation avec la figure 7B.

Dans la partie droite de la figure 8A, une métallisation M8 est solidaire de la région de drain 51 du transistor PMOS_{DF}. La métallisation M8 est également reliée à la borne de cathode K. Une métallisation de grille M7-3 du transistor PMOS_{D} est également reliée à la borne C. Une métallisation M9 recouvre la région P⁺ 53/18 de drain du transistor PMOS_{D} et de caisson du transistor NMOS_{D} ainsi que la région de source du transistor NMOS_{D} et la région d'isolement de grille du transistor NMOS_{D}.

Le mode de fonctionnement de ce composant résulte clairement des schémas des figures 8B et 8C. Tant que la tension sur le point intermédiaire C du diviseur de tension 2 est inférieure à la tension de seuil du transistor PMOS_{DF}, ce transistor est passant et le transistor NMOS_{D} ou l'IGBT à déplétion limite le courant à une valeur Ion qui dépend de leurs caractéristiques. Dès que la tension sur le point intermédiaire C dépasse la tension de seuil susmentionnée, le transistor PMOS_{DF} devient bloquant et il ne circule plus entre les bornes A et K qu'un courant de fuite très faible Ioff qui correspond au courant dans le diviseur 2.

Les figures 9A et 9B illustrent une vue en coupe schématique et un schéma équivalent d'un composant semiconducteur selon un deuxième exemple de réalisation de la présente invention. Ce mode de réalisation utilise un limiteur du type illustré en figures 5A et 5B. Le montage d'ensemble s'apparente à celui représenté sous forme de blocs en figure 2A. Le limiteur 1, comprenant un transistor NPN et un transistor NMOS_{D}, est connecté entre les bornes A et K. La borne de base du transistor bipolaire est connectée à la borne de cathode par l'intermédiaire d'un transistor MOS à canal N à enrichissement NMOS_{E} dont la grille est connectée à la borne de sortie C du pont diviseur 2.

On retrouve ces divers composants en figure 9A. La partie gauche de la figure 9A qui correspond au pont diviseur 2 est identique à la partie gauche de la figure 8A et comporte les transistors NMOS_{D}1 et NMOS_{D}2 ainsi que la diode zener Z. En ce qui concerne la partie droite de la figure, une variante a été introduite par rapport à la représentation de la figure 5B à savoir que les transistors NPN et NMOS_{D} sont réalisés dans des caissons distincts. Le transistor NPN apparaît à la partie centrale de la figure. Son caisson de base est désigné par la référence 61. Le transistor NMOS_{D} apparaît dans la partie droite de la figure. On a représenté, entre le transistor NPN et le transistor NMOS_{D} un exemple de réalisation du transistor à enrichissement NMOS_{E} réalisé sous forme d'un transistor MOS latéral classique qui comprend, dans un caisson 62, une région de drain 63, une région de source 64, et une région de canal 65 surmontée d'une région d'isolement de grille 66.

Les métallisations sur la région de diviseur de tension sont identiques à celles de la figure 8A et sont désignées par les mêmes références M6, M7-1, M7-2. Comme en figure 5B, l'émetteur 21 du transistor NPN est revêtu d'une métallisation M3 reliée à la borne K. La base 61 du transistor NPN est solidaire d'une métallisation M4-1 reliée à une métallisation M4-2 correspondant à la connexion caisson/source/grille du transistor NMOS_{D}. Le drain 63, l'isolant de grille 66 et la source 64 du transistor NMOS_{E} portent respectivement des métallisations M10, M11 et M12. La métallisation M10 est reliée aux métallisations M4-1/M4-2 ; la métallisation M11 aux métallisations M7-1/M7-2 ; la métallisation M12 à la borne K.

Le fonctionnement de ce composant est le suivant. Tant que la tension sur la borne C est inférieure à la tension de seuil du transistor NMOS_{E}, ce transistor est bloqué et le transistor NPN assure, grâce à la connexion entre sa base et son collecteur par le transistor NMOS_{D}, le passage d'un courant limité constant Ion entre les bornes A et K. Dès que la tension sur la borne C dépasse la tension de seuil du transistor NMOS_{E}, celui-ci devient passant et court-circuite la jonction base-émetteur du transistor NPN amenant ce transistor à l'état bloqué. Il ne circule alors plus qu'un courant Ioff entre les bornes A et K, ce courant Ioff correspondant pour l'essentiel au courant dans le pont diviseur 2.

### EXEMPLE NUMERIOUE

Uniquement à titre d'exemple et sans que cela constitue une limitation de la présente invention, on va indiquer ci-dessous des valeurs numériques possibles applicables à la structure représentée schématiquement en figure 8A.

Cette structure peut être formée à partir d'une tranche de silicium de type N dans un plan <100> ayant une résistance de couche de 30 ohm.cm.

Si l'on désigne par Cs la concentration superficielle d'une région et par xj la profondeur de jonction, on peut choisir pour les diverses régions les paramètres suivants.

| | Cs(at/cm³) | xj(µm) |
|---|---|---|
| régions P⁺ (118,51,53) | 1,1.10¹⁹ | 4,35 |
| régions P (14,30,40,52,114) | 3.10¹⁶ | 2,5 |
| régions N⁺ (15,31,32,41,115) | 6.10¹⁹ | 1,15 |
| canaux N (16,33,116) | 4,5.10¹⁷ | |

Les épaisseurs de grilles peuvent être de l'ordre de 50 nm. Les dimensions horizontales des caissons sont celles couramment choisies dans le domaine des transistors MOS de puissance, c'est-à-dire de l'ordre de 25 à 50 µm.

Avec de tels paramètres, on obtient des dispositifs supportant des tensions de 600 à 1500 V, dont le courant Ion est de 1 à 5 A et le courant Ioff de 1 à 10 mA.

### VARIANTES

Bien entendu, comme on l'a déjà indiqué au cours de cette description, chacun des éléments décrits à titre d'exemple est susceptible de diverses variantes et pourra être constitué d'une ou plusieurs cellules. La présente invention est susceptible de nombreuses variantes et modifications qui apparaîtront à l'homme de l'art. Celui-ci devra essentiellement assembler de façon monolithique les éléments suivants.
- Un limiteur de courant. Ce limiteur doit pouvoir dissiper une énergie relativement importante. Ce sera de préférence un limiteur de courant dont le composant principal de passage de courant est un composant réalisé sous forme verticale. Les quatre modes de réalisation de limiteurs de courant décrits précédemment ne constituent que des exemples. L'homme de métier pourra prévoir d'autres limiteurs de courant assurant la même fonction ou des variantes des limiteurs de courant décrits. Par exemple, les transistors bipolaires pourront être transformés en des montages Darlington, et l'on pourra également prévoir des associations de transistors MOS.
- Un détecteur de tension. On a décrit ici en détail seulement un détecteur de tension du type diviseur à transistors MOS à déplétion. L'homme de l'art saura choisir les dimensions et les résistances à l'état passant des transistors pour que la tension VC atteigne une valeur choisie quand la tension VAK atteint une valeur prédéterminée. D'autres diviseurs, résistifs ou à transistors, pourront être utilisés. De plus, d'autres types de détecteurs de tension pourront être prévus ou bien pour fournir une indication qui croît régulièrement jusqu'à ce qu'on atteigne une valeur prédéterminée ou bien pour fournir une sortie qui varie de façon binaire quand un certain seuil est atteint. Un tel circuit peut par exemple être constitué d'un comparateur recevant la sortie d'un diviseur de tension du type décrit.
- Un interrupteur, intégré ou non au limiteur de courant dont le rôle est de supporter la tension à l'état bloqué.

En outre, d'autres associations de limiteur de courant, détecteur de tension et interrupteur pourront être prévues du moment qu'elles sont compatibles et peuvent former un composant monolithique.

## Revendications

1. Composant limiteur de courant et disjoncteur comprenant, entre deux bornes (A) et (K), un limiteur de courant à conduction unidirectionnelle, fournissant un courant constant (1),
un détecteur (2) de la tension entre lesdites bornes, **caractérisé en ce qu'**il comprend en outre:
un moyen d'inhibition de la conduction du limiteur de courant quand la tension détectée dépasse un seuil déterminé et **en ce qu'**il s'agit d'un composant statique et monolithique.

2. Composant selon la revendication 1, **caractérisé en ce que** le détecteur de tension (2) est un diviseur de tension connecté entre lesdites bornes.

3. Composant selon la revendication 2, **caractérisé en ce que** le diviseur de tension comprend deux transistors MOS à déplétion à canal N (NMOS_{D}1, NMOS_{D}2) connectés en série entre lesdites bornes (A, K).

4. Composant selon la revendication 1, **caractérisé en ce que** le moyen d'inhibition est un commutateur statique (3) en série avec le limiteur de courant.

5. Composant selon la revendication 1, **caractérisé en ce que** le limiteur de courant est un transistor MOS à canal N à déplétion de type vertical (NMOS_{D}).

6. Composant selon la revendication 1, **caractérisé en ce que** le limiteur de courant est un transistor vertical de type IGBT à déplétion (IGBT_{D}).

7. Composant selon la revendication 1, **caractérisé en ce que** le limiteur de courant est un transistor bipolaire NPN dont le collecteur est relié à la base par l'intermédiaire d'un transistor MOS à canal N à déplétion (NMOS_{D}).

8. Composant selon la revendication 1, **caractérisé en ce que** le limiteur de courant est un transistor MOS latéral à canal P à déplétion à substrat flottant (PMOS_{DF}) dont le drain est connecté à la cathode d'un thyristor vertical (TH), un transistor MOS à canal N à déplétion (NMOS_{D}) étant disposé entre cathode et gâchette d'anode du thyristor.

9. Composant selon la revendication 3, **caractérisé en ce que** le diviseur comprend un premier transistor MOS à canal N à déplétion de type vertical (NMOS_{D}1) et un deuxième transistor MOS à canal N à déplétion de type latéral (NMOS_{D}2).

10. Composant selon la revendication 1, **caractérisé en ce qu'**il comprend un diviseur de tension selon la revendication 3, un limiteur de courant selon l'une des revendications 5 ou 6, et un moyen d'inhibition selon la revendication 4 constitué d'un transistor MOS à canal P à déplétion à substrat flottant (PMOS_{DF}).

11. Composant selon la revendication 10, **caractérisé en ce qu'**il comprend en outre une diode zener (41) en parallèle sur le transistor MOS à déplétion (NMOS_{D}2) du limiteur de courant connecté entre la borne la plus négative des deux dites bornes et la grille du transistor MOS à canal P à déplétion à substrat flottant (PMOS_{DF}).

12. Composant selon la revendication 1, **caractérisé en ce qu'**il comprend, un diviseur de tension selon la revendication 3, un limiteur de courant selon la revendication 7, et un moyen d'inhibition constitué d'un transistor MOS à canal N à enrichissement (NMOS_{E}) connecté entre grille et émetteur dudit transistor NPN.

## Patentansprüche

1. Strombegrenzer- und Unterbrecherschalter-Bauteil, das zwischen zwei Anschlüssen (A) und (K) einen Strombegrenzer (1) mit unidirektionaler Stromleitung, der einen konstanten Strom liefert, sowie einen Detektor (2) für die Spannung zwischen den genannten Anschlüssen aufweist,
**dadurch gekennzeichnet daß** das Bauteil des weiteren eine Vorrichtung zum Sperren der Leitung des Strombegrenzers aufweist, wenn die nachgewiesene Spannung einen vorbestimmten Schwellwert übersteigt, und daß es sich um ein statisches und monolithisches Bauteil handelt.

2. Bauteil nach Anspruch 1, **dadurch gekennzeichnet,**
**daß** der Spannungsdetektor (2) ein zwischen den genannten Anschlüssen liegender Spannungsteiler ist.

3. Bauteil nach Anspruch 2, **dadurch gekennzeichnet,**
**daß** der Spannungsteiler zwei in Reihe zwischen den genannten Anschlüssen (A, K) geschaltete N-Kanal-Verarmungs-MOS-Transistoren (NMOS_{D}1, NMOS_{D}2) umfaßt.

4. Bauteil nach Anspruch 1, **dadurch gekennzeichnet,**
**daß** die Sperrvorrichtung ein in Reihe mit dem Strombegrenzer liegender statischer Umschalter (3) ist.

5. Bauteil nach Anspruch 1, **dadurch gekennzeichnet,**
**daß** der Strombegrenzer ein N-Kanal-Verarmungs-MOS-Transistor (NMOS_{D}) vom Vertikaltyp ist.

6. Bauteil nach Anspruch 1, **dadurch gekennzeichnet,**
**daß** der Strombegrenzer ein vertikaler IGBT-Transistor vom Verarmungstyp (IGBT_{D}) ist.

7. Bauteil nach Anspruch 1, **dadurch gekennzeichnet,**
**daß** der Strombegrenzer ein NPN-Bipolartransistor ist, dessen Kollektor über einen N-Kanal-Verarmungs-MOS-Transistor (NMOS_{D}) mit seinem Basisanschluß verbunden ist.

8. Bauteil nach Anspruch 1, **dadurch gekennzeichnet,**
**daß** der Strombegrenzer ein lateraler P-Kanal-Verarmungs-MOS-Transistor mit flottierendem Substrat (PMOS_{DF}) ist, dessen Drain-Anschluß mit der Kathode eines Vertikal-Thyristors (TH) verbunden ist, und daß zwischen der Kathode und dem Anodengate des Thyristors ein N-Kanal-Verarmungs-MOS-Transistor (NMOS_{D}) angeordnet ist.

9. Bauteil nach Anspruch 3, **dadurch gekennzeichnet,**
**daß** der Spannungsteiler einen ersten N-Kanal-Verarmungs-MOS-Transistor vom Vertikaltyp (NMOS_{D}1) und einen zweiten N-Kanal-Verarmungs-MOS-Transistor vom Lateraltyp (NMOS_{D}2) umfaßt.

10. Bauteil nach Anspruch 1, **dadurch gekennzeichnet,**
**daß** es einen Spannungsteiler nach Anspruch 3, einen Strombegrenzer nach einem der Ansprüche 5 oder 6, sowie eine aus einem P-Kanal-Verarmungs-MOS-Transistor mit flottierendem Substrat (PMOS_{DF}) bestehende Sperrvorrichtung nach Anspruch 4 umfaßt.

11. Bauteil nach Anspruch 10, **dadurch gekennzeichnet, daß** es des weiteren eine Zenerdiode (41) parallel zu dem Verarmungs-MOS-Transistor (NMOS_{D}2) des Strombegrenzers zwischen dem negativeren der beiden genannten Anschlüsse und dem Gate des P-Kanal-Verarmungs-MOS-Transistors mit flottierendem Substrat (PMOS_{DF}) umfaßt.

12. Bauteil nach Anspruch 1, **dadurch gekennzeichnet, daß** es einen Spannungsteiler nach Anspruch 3, einen Strombegrenzer nach Anspruch 7, und eine Sperrvorrichtung umfaßt, die von einem zwischen dem Gate und dem Emitter des genannten NPN-Transistors angeschlossenen N-Kanal-Anreicherungs-MOS-Transistor (NMOS_{E}) gebildet wird.

## Claims

1. A current limiter and circuit-breaker component including, between two terminals (A) and (K), a one-way current limiter (1) providing a constant current, and a sensor (2) of the voltage between said terminals, **characterized in that** it further comprises means for inhibiting the conduction of the current limiter when the voltage sensed exceeds a selected threshold and **in that** the component is static and monolithic.

2. A component according to claim 1, **characterized in that** the voltage sensor (2) is a voltage divider connected between said terminals.

3. A component according to claim 2, **characterized in that** the voltage divider includes two N-channel MOS depletion transistors (NMOS_{D}1, NMOS_{D}2) connected in series between said terminals (A, K).

4. A component according to claim 1, **characterized in that** the inhibition means is a static switch (3) in series with the current limiter.

5. A component according to claim 1, **characterized in that** the current limiter is a vertical-type N-channel MOS depletion transistor (NMOS_{D}).

6. A component according to claim 1, **characterized in that** the current limiter is a vertical IGBT-type depletion transistor (IGBT_{D}).

7. A component according to claim 1, **characterized in that** the current limiter is a bipolar NPN transistor having its collector connected to its base via an N-channel MOS depletion transistor (NMOS_{D}).

8. A component according to claim 1, **characterized in that** the current limiter is a lateral P-channel MOS depletion floating-substrate transistor (PMOS_{DF}) having its drain connected to the cathode of a vertical thyristor (TH), an N-channel MOS depletion transistor (NMOS_{D}) being placed between the cathode and the anode gate of the thyristor.

9. A component according to claim 3, **characterized in that** the divider includes a first vertical N-channel MOS depletion transistor (NMOS_{D}1) and a second lateral N-channel MOS depletion transistor (NMOS_{D}2).

10. A component according to claim 1, **characterized in that** it includes a voltage divider according to claim 3, a current limiter according to one of claims 5 or 6, and inhibition means according to claim 4 constituted by a P-channel MOS depletion floating-substrate transistor (PMOS_{DF}).

11. A component according to claim 10, **characterized in that** it further includes a zener diode (41) mounted in parallel on the MOS depletion transistor (NMOS_{D}2) of the current limiter connected between the most negative terminal of the two terminals and the gate of the P-channel MOS depletion floating-substrate transistor (PMOS_{DF}).

12. A component according to claim 1, **characterized in that** it includes a voltage divider according to claim 3, a current limiter according to claim 7, and an inhibition means constituted by an N-channel MOS enhancement transistor (NMOS_{E}) connected between the gate and the emitter of the NPN transistor.
